# EUROPEAN PATENT SPECIFICATION

(11) **EP 4 440 285 B1**
(45) Date of publication and mention of the grant of the patent: **19.11.2025**
(21) Application number: 24163242.1
(22) Date of filing: 13.03.2024
(51) Int. Cl.: H10K 59/60

(54) **DISPLAY PANEL AND ELECTRONIC DEVICE**
ANZEIGETAFEL UND ELEKTRONISCHE VORRICHTUNG
PANNEAU D'AFFICHAGE ET DISPOSITIF ÉLECTRONIQUE

(30) Priority: 22.03.2023 KR 20230037291
(43) Date of publication of application: 02.10.2024
(73) Proprietor: Samsung Display Co., Ltd., Yongin-si, Gyeonggi-do 17113 (KR)
(72) Inventor: HEO, Chul Joon, 16678 Suwon-si (KR); PARK, Kyung Bae, 16678 Suwon-si (KR); PARK, Jeong Il, 16678 Suwon-si (KR); MINAMI, Daiki, 16678 Suwon-si (KR); SEO, Hwijoung, 16678 Suwon-si (KR); YUN, Sungyoung, 16678 Suwon-si (KR); LIM, Younhee, 16678 Suwon-si (KR); LIM, Juhyung, 16678 Suwon-si (KR)
(74) Representative: Elkington and Fife LLP

(56) References cited:
- EP-A1- 3 637 472
- EP-A1- 3 965 072
- TAISUKE KAMADA ET AL: "OLED display incorporating organic photodiodes for fingerprint imaging", JOURNAL OF THE SOCIETY FOR INFORMATION DISPLAY - SID, vol. 27, no. 6, 15 April 2019 (2019-04-15), US, pages 361 - 371, XP055738697, ISSN: 1071-0922, DOI: 10.1002/jsid.786

## Description

### FIELD OF THE INVENTION

Display panels and electronic devices are disclosed.

### BACKGROUND OF THE INVENTION

Recently, there is an increasing demand for a display device implementing a biometric recognition technology that authenticates the person by extracting specific biometric information or behavioral characteristic information of a person with an automated device centering on finance, healthcare, or mobile. Accordingly, the display device may include a sensor for biometric recognition.

On the other hand, such a sensor for biometric recognition may be divided into an electrostatic type, an ultrasonic type, or an optical type. Among them, the optical type sensor is a sensor configured to absorb light and convert the absorbed light into an electrical signal. The organic material has a large extinction coefficient and may be configured to selectively absorb light in a predetermined wavelength region according to a molecular structure, and thus it may be usefully applied to an optical type sensor.

Meanwhile, the sensor provided in the display device may be under the display panel or may be manufactured as a separate module and mounted outside the display panel. However, when the sensor is under the display panel, the object should be recognized through the display panel, various films, and/or parts, and thus performance may be degraded. When the sensor is manufactured and mounted as a separate module, there are limitations in terms of design and usability. Accordingly, a sensor embedded in a display panel has been studied.

Displays comprising sensors are known from, amongst others, EP 3 637 472 A1, EP 3 965 072 A1, and TAISUKE KAMADA ET AL: "OLED display incorporating organic photodiodes for fingerprint imaging", J. Soc. Inf. Disp., 2019, 27(6), 361-371.

### SUMMARY OF THE INVENTION

Some example embodiments provide display panels capable of implementing a high-sensitivity sensor while improving display quality.

Some example embodiments provide electronic devices including the display panel.

According to an example embodiment, a display panel may include a substrate, first, second, and third light emitting diodes on the substrate and configured to emit light of first, second, and third wavelength spectra belonging to a visible light wavelength spectrum, respectively, the first, second, and third wavelength spectra being different from each other in a visible light spectrum, a first organic photoelectric conversion diode overlapping the first light emitting diode along a thickness direction of the substrate and configured to selectively absorb light of the second and third wavelength spectra and convert the light of the second and third wavelength spectra into an electrical signal, a second organic photoelectric conversion diode overlapping the second light emitting diode along the thickness direction of the substrate and configured to selectively absorb light of the first and third wavelength spectra and convert the light of the first and third wavelength spectra into an electrical signal, and a third organic photoelectric conversion diode overlapping the third light emitting diode along the thickness direction of the substrate and configured to selectively absorb light of the first and second wavelength spectra and convert the light of the first and second wavelength spectra into an electrical signal.

The first, second, and third light emitting diodes may be arranged in parallel along an in-plane direction of the substrate and the first, second, and third organic photoelectric conversion diodes may be arranged in parallel along an in-plane direction of the substrate, the first, second, and third organic photoelectric conversion diodes being on the first, second, and third light emitting diodes.

An area of the first organic photoelectric conversion diode may be greater than or equal to an area of the first light emitting diode, an area of the second organic photoelectric conversion diode may be greater than or equal to an area of the second light emitting diode, and an area of the third organic photoelectric conversion diode may be greater than or equal to an area of the third light emitting diode.

The first organic photoelectric conversion diode may be configured to transmit light of the first wavelength spectrum emitted from the first light emitting diode, a full width at half maximum (FWHM) of the first wavelength spectrum transmitted through the first organic photoelectric conversion diode may be narrower than a FWHM of the first wavelength spectrum emitted from the first light emitting diode, the second organic photoelectric conversion diode may be configured to transmit light of the second wavelength spectrum emitted from the second light emitting diode, a FWHM of the second wavelength spectrum transmitted through the second organic photoelectric conversion diode may be narrower than a FWHM of the second wavelength spectrum emitted from the second light emitting diode, the third organic photoelectric conversion diode may be configured to transmit light of the third wavelength spectrum emitted from the third light emitting diode, and a FWHM of the third wavelength spectrum transmitted through the third organic photoelectric conversion diode may be narrower than a FWHM of the third wavelength spectrum emitted from the third light emitting diode.

The first, second, and third light emitting diodes and the first, second, and third organic photoelectric conversion diodes may share a common electrode for applying a common voltage to the first, second, and third light emitting diodes and the first, second, and third organic photoelectric conversion diodes.

The first, second, and third light emitting diodes may include first pixel electrodes for the first, second, and third light emitting diodes, the first pixel electrodes facing the common electrode and separated from each other, the first, second, and third organic photoelectric conversion diodes may include second pixel electrodes for first, second, and third organic photoelectric conversion diodes, the second pixel electrodes facing the common electrode and separated from each other, and the first pixel electrodes and the second pixel electrodes may be electrically connected to different thin film transistors from each other.

The first organic photoelectric conversion diode may include (1) an organic photoelectric conversion material capable of selectively absorbing light of the second wavelength spectrum and the third wavelength spectrum or (2) a combination of an organic photoelectric conversion material capable of selectively absorbing light of the second wavelength spectrum and an organic photoelectric conversion material capable of selectively absorbing light of the third wavelength spectrum. The second organic photoelectric conversion diode may include (1) an organic photoelectric conversion material capable of selectively absorbing light of the first wavelength spectrum and the third wavelength spectrum or (2) a combination of an organic photoelectric conversion material capable of selectively absorbing light of the first wavelength spectrum and an organic photoelectric conversion material capable of selectively absorbing light of the third wavelength spectrum. The third organic photoelectric conversion diode may include (1) an organic photoelectric conversion material capable of selectively absorbing light of the first wavelength spectrum and the second wavelength spectrum or (2) a combination of an organic photoelectric conversion material capable of selectively absorbing light of the first wavelength spectrum and an organic photoelectric conversion material capable of selectively absorbing light of the second wavelength spectrum.

The first wavelength spectrum may be a blue wavelength spectrum having a peak wavelength in a wavelength spectrum of greater than or equal to about 380 nm and less than about 500 nm, the second wavelength spectrum may be a green wavelength spectrum having a peak wavelength in a wavelength spectrum of about 500 nm to about 600 nm, and the third wavelength spectrum may be a red wavelength spectrum having a peak wavelength in a wavelength spectrum of greater than about 600 nm and less than about 750 nm.

At least one of the second organic photoelectric conversion diode or the third organic photoelectric conversion diode is configured to sense the light of the first wavelength spectrum emitted from the first light emitting diode and reflected by a recognition target, at least one of the first organic photoelectric conversion diode or the third organic photoelectric conversion diode is configured to sense the light of the second wavelength spectrum emitted from the second light emitting diode and reflected by the recognition target, and at least one of the first organic photoelectric conversion diode or the second organic photoelectric conversion diode is configured to sense the light of the third wavelength spectrum emitted from the third light emitting diode and reflected by the recognition target.

According to an example embodiment, a display panel may include a subpixel array including a first subpixel configured to display a first color, a second subpixel configured to display a second color, and a third subpixel configured to display a third color and a sensor pixel array including a first sensor pixel overlapping the first subpixel, a second sensor pixel overlapping the second subpixel, and a third sensor pixel overlapping the third subpixel, wherein the first sensor pixel may be configured to sense light in a visible light wavelength spectrum excluding the wavelength spectrum corresponding to the first color, the second sensor pixel may be configured to sense light in a visible light wavelength spectrum excluding the wavelength spectrum corresponding to the second color, and the third sensor pixel may be configured to sense light of a visible light wavelength spectrum excluding a wavelength spectrum corresponding to the third color.

The sensor pixel array may be on the subpixel array.

The first sensor pixel may be greater than or equal to the first subpixel, the second sensor pixel may be greater than or equal to the second subpixel, and the third sensor pixel may be greater than or equal to the third subpixel.

The first, second, and third subpixels and the first, second, and third sensor pixels may be configured to be independently driven.

First thin film transistors may be electrically connected to the first, second, and third subpixels, respectively, and each of the first thin film transistors may be configured to provide a forward bias, and second thin film transistors may be electrically connected to the first, second, and third sensor pixels, respectively, and each of the second thin film transistors may be configured to provide a reverse bias.

The first subpixel may include a first light emitting diode configured to emit light of a first wavelength spectrum corresponding to the first color, the second subpixel may include a second light emitting diode configured to emit light of a second wavelength spectrum corresponding to the second color, and the third subpixel may include a third light emitting diode configured to emit light of a third wavelength spectrum corresponding to the third color.

The first sensor pixel may include a first organic photoelectric conversion diode configured to selectively absorb light of the second and third wavelength spectra and to convert the absorbed light of the second and third wavelength spectra into an electrical signal, the second sensor pixel may include a second organic photoelectric conversion diode configured to selectively absorb light of the first and third wavelength spectra and to convert the absorbed light of the first and third wavelength spectra into an electrical signal, and the third sensor pixel may include a third organic photoelectric conversion diode configured to selectively absorb light of the first and second wavelength spectra and to convert the absorbed light of the first and second wavelength spectra into an electrical signal.

According to an example embodiment, there is provided an electronic device that includes the aforementioned display panel.

According to an example embodiment, a method of operating the electronic device includes sensing an image of a user's recognition target by performing at least one of (1) driving the first subpixel and driving the second and the third sensor pixels to sense light of a first wavelength spectrum corresponding to the first color reflected by a recognition target of a user, (2) driving the second subpixel and driving the first sensor pixel and the third sensor pixel to sense light of a second wavelength spectrum corresponding to the second color reflected by a recognition target of a user, or (3) driving the third subpixel and driving the first sensor pixel and the second sensor pixel to sense light of a third wavelength spectrum corresponding to the third color reflected by a recognition target of a user, determining a matching between an image of the recognition target sensed by the first, second and/or third sensor pixels and a pre-stored contrast image, and displaying an image by turning off the first, second and/or third sensor pixels and driving at least one of the first, second, or third subpixels when a result of the determining indicates that the image of the recognition target matches the pre-stored contrast image.

The first sensor pixel, the second sensor pixel, and the third sensor pixel may be configured to be driven under a reverse bias, and the first subpixel, the second subpixel, and the third subpixel may be configured to be driven under a forward bias.

Display quality may be improved, and a high-sensitivity sensor may be implemented.

### BRIEF DESCRIPTION OF THE DRAWINGS

FIG. 1 is a perspective view showing a display panel according to an example embodiment,
FIG. 2 is a plan view illustrating the display panel of FIG. 1,
FIG. 3 is a cross-sectional view showing an example of the display panel of FIGS. 1 and 2,
FIG. 4 is a cross-sectional view showing an example of a subpixel array and a sensor array of the display panel of FIG. 3,
FIG. 5 is a schematic view illustrating an electronic device according to an example embodiment,
FIG. 6 is a driving timing diagram illustrating an operating method for performing a biometric recognition function of an electronic device according to an example embodiment, and
FIG. 7 is a flowchart illustrating an example method of operating an electronic device including a display panel according to an example embodiment.

### DETAILED DESCRIPTION

Hereinafter, some example embodiments will be described in detail so that a person skilled in the art would understand the same. However, a structure that is actually applied may be implemented in various different forms and is not limited to the example embodiments described herein.

In the drawings, the thickness of layers, films, panels, regions, etc., are exaggerated for clarity. It will be understood that when an element such as a layer, film, region, or substrate is referred to as being "on" another element, it may be directly on the other element or intervening elements may also be present. In contrast, when an element is referred to as being "directly on" another element, there are no intervening elements present.

In the drawings, parts having no relationship with the description are omitted for clarity of the embodiments, and the same or similar constituent elements are indicated by the same reference numeral throughout the specification.

Hereinafter, the terms "lower" and "upper" are used for better understanding and ease of description, but do not limit the location relationship.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

As used herein, expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

Hereinafter, when a definition is not otherwise provided, the energy level is the highest occupied molecular orbital (HOMO) energy level or the lowest unoccupied molecular orbital (LUMO) energy level.

Hereinafter, when a definition is not otherwise provided, a work function or an energy level is expressed as an absolute value from a vacuum level. In addition, when the work function or the energy level is referred to be deep, high, or large, it may have a large absolute value based on "0 eV" of the vacuum level whereas when the work function or the energy level is referred to be shallow, low, or small, it may have a small absolute value based on "0 eV" of the vacuum level. Further, the differences between the work function and/or the energy level may be values obtained by subtracting a small value of the absolute value from a large value of the absolute value.

Hereinafter, when a definition is not otherwise provided, the HOMO energy level may be evaluated with an amount of photoelectrons emitted by energy when irradiating UV light to a thin film using AC-2 (Hitachi) or AC-3 (Riken Keiki Co., Ltd.).

Hereinafter, when a definition is not otherwise provided, the LUMO energy level may be obtained by obtaining an energy bandgap using a UV-Vis spectrometer (Shimadzu Corporation), and then calculating the LUMO energy level from the energy bandgap and the already measured HOMO energy level.

Hereinafter, when a definition is not otherwise provided, "wavelength spectrum" includes emission spectrum and/or absorption spectrum.

Hereinafter, when a definition is not otherwise provided, "peak wavelength" includes "peak emission wavelength" and/or "peak absorption wavelength."

Hereinafter, "wavelength region" and "wavelength spectrum" may be used interchangeably.

Hereinafter, a display panel according to some example embodiments will be described.

The display panel according to some example embodiments may be a display panel capable of performing a display function and a recognition function (e.g., biometric recognition function), and may be an in-cell type display panel in which a sensor performing a recognition function (e.g., biometric recognition function) is embedded in the display panel.

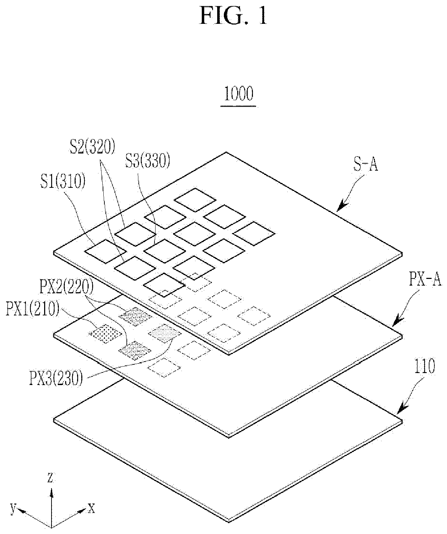

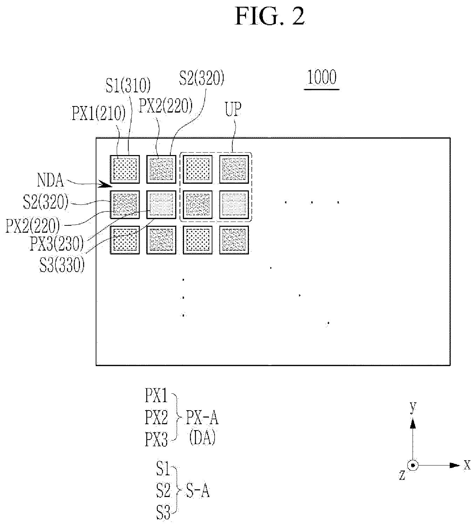

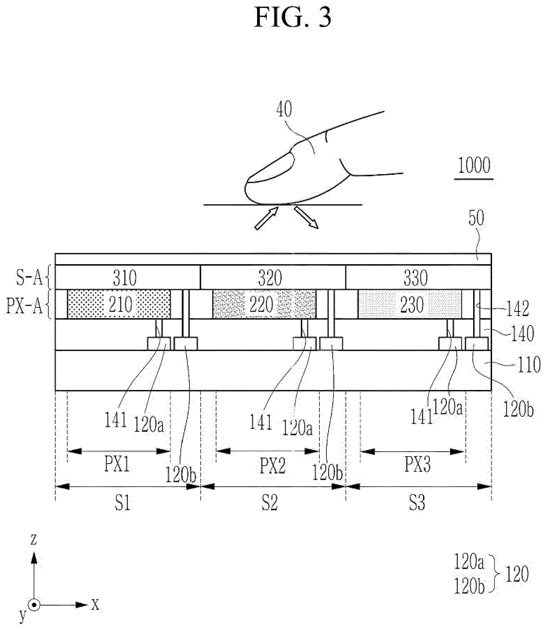

FIG. 1 is a perspective view showing a display panel according to an example embodiment and FIG. 2 is a plan view illustrating the display panel of FIG. 1, and FIG. 3 is a cross-sectional view showing an example of the display panel of FIGS. 1 and 2.

Referring to FIGS. 1 and 2, a display panel 1000 according to an example embodiment includes a subpixel array PX-A including a plurality of first, second, and third subpixels PX1, PX2, and PX3 configured to display different colors from each other and a sensor pixel array S-A including a plurality of first, second, and third sensor pixels S1, S2, and S3.

The subpixel array PX-A and the sensor pixel array S-A overlap each other along a thickness direction (e.g., z direction) of the substrate 110, and the sensor pixel array S-A is on the subpixel array PX-A. The display panel 1000 according to this example embodiment is a top emission type display panel in which light is emitted to a side of the substrate 110 that does not face the subpixel array PX-A, and thus the sensor pixel array S-A may be closer to a user (observer) than the subpixel array PX-A.

The subpixel array PX-A may be configured to display at least three primary colors by combining the first subpixel PX1, the second subpixel PX2, and/or the third subpixel PX3. The subpixel array PX-A may be configured to display at least three primary colors. The first subpixel PX1, the second subpixel PX2, and the third subpixel PX3 may be configured to display different a first color, a second color, and a third color selected from, for example, blue, green, and red colors. For example, the first color, the second color, and the third color may be blue, green, and red, respectively. The first subpixel PX1 may be a blue subpixel configured to display blue, the second subpixel PX2 may be a green subpixel configured to display green, and the third subpixel PX3 may be a red subpixel configured to display red. However, the present disclosure is not limited thereto and may further include an auxiliary subpixel (not shown) such as a white subpixel. The first subpixel PX1, the second subpixel PX2, and the third subpixel PX3 may be independently driven by each thin film transistor TFT, and the thin film transistor TFT electrically connected to the first subpixel PX1, the second subpixel PX2, or the third subpixel PX3 may provide a forward bias to each of the first subpixel PX1, the second subpixel PX2, or the third subpixels PX3.

At least one first subpixel PX1, at least one second subpixel PX2, and at least one third subpixel PX3 form one unit pixel UP and may be repeatedly arranged along the entire surface of the display panel 1000 along rows and/or columns. In FIG. 2, a structure in which the unit pixel UP includes one first subpixel PX1, two second subpixels PX2, and one third subpixel PX3 is illustrated as an example, but the present disclosure is not limited thereto. An area occupied by a plurality of first, second, and third subpixels PX1, PX2, and PX3 and displaying colors by the plurality of first, second, and third subpixels PX1, PX2, and PX3 may be a display area DA configured to display an image.

The sensor pixel array S-A may include a first sensor pixel S1, a second sensor pixel S2, and a third sensor pixel S3 configured to selectively sense a portion of the visible light wavelength spectrum, and a combination of the first sensor pixel S1, the second sensor pixel S2, and the third sensor pixel S3 may be configured to sense light of at least a visible light wavelength spectrum. Each of the first sensor pixel S1, the second sensor pixel S2, and the third sensor pixel S3 may include an optical recognition sensor (e.g., a biometric sensor), and each may be configured to selectively absorb a portion of the visible light wavelength spectrum and convert the absorbed light into an electrical signal. The first sensor pixel S1, the second sensor pixel S2, and the third sensor pixel S3 may be independently driven by each thin film transistor TFT, and the thin film transistor TFT electrically connected to the first sensor pixel S1, the second sensor pixel S2, or the third sensor pixel S3 provides a reverse bias to the first sensor pixel S1, the second sensor pixel S2, or the third sensor pixels S3.

The first sensor pixel S1 is on the first subpixel PX1 and overlaps the first subpixel PX1. The first sensor pixel S1 may be larger than or equal to the first subpixel PX1, and accordingly, when viewed from a plan view of FIG. 2, the first subpixel PX1 may be completely surrounded by the first sensor pixel S1. For example, in FIG. 2, each edge of the first subpixel PX1 may be within the first sensor pixel S1. The first sensor pixel S1 may be configured to sense light of a visible light wavelength spectrum excluding the wavelength spectrum corresponding to the first color displayed by the first subpixel PX1. For example, when the first subpixel PX1 is a blue subpixel, the first sensor pixel S1 may be configured to selectively sense light of a green to red wavelength spectrum, other than the blue wavelength spectrum, among the visible light wavelength spectrum.

The second sensor pixel S2 is on the second subpixel PX2 and overlaps the second subpixel PX2. The second sensor pixel S2 may be larger than or equal to the second subpixel PX2, and accordingly, when viewed from a plan view of FIG. 2, the second subpixel PX2 may be completely surrounded by the second sensor pixel S2. For example, in FIG. 2, each edge of the second subpixel PX2 may be within the second sensor pixel S2. The second sensor pixel S2 may be configured to sense light of a visible light wavelength spectrum excluding the wavelength spectrum corresponding to the second color displayed by the second subpixel PX2. When the second subpixel PX2 is a green subpixel, the second sensor pixel S2 may be configured to selectively sense light of a blue wavelength spectrum and a red wavelength spectrum, other than the green wavelength, spectrum among the visible light wavelength spectrum.

The third sensor pixel S3 is on the third subpixel PX3 and overlaps the third subpixel PX3. The third sensor pixel S3 may be larger than or equal to the third subpixel PX3, and accordingly, when viewed from a plan view of FIG. 2, the third subpixel PX3 may be completely surrounded by the third sensor pixel S3. For example, in FIG. 2, each edge of the third subpixel PX3 may be within the third sensor pixel S3. The third sensor pixel S3 may be configured to sense light of a visible light wavelength spectrum excluding the wavelength spectrum corresponding to the third color displayed by the third subpixel PX3. For example, when the third subpixel PX3 is a red subpixel, the third sensor pixel S3 may be configured to selectively sense light of a blue to green wavelength spectrum, other than the red wavelength spectrum, among the visible light wavelength spectrum.

Referring to FIG. 3, a display panel 1000 according to an example embodiment includes a substrate 110, a thin film transistor 120 formed on the substrate 110, an insulation layer 140 formed on the thin film transistor 120, first, second, and third light emitting diodes 210, 220, and 230 formed on the insulation layer 140, first, second, and third organic photoelectric conversion diodes 310, 320, and 330 formed on the first, second, and third light emitting diodes 210, 220, and 230, respectively, and an encapsulation layer 50. The first, second, and third light emitting diodes 210, 220, and 230 are included in the first subpixel PX1, the second subpixel PX2, and the third subpixel PX3, respectively. The first, second and third organic photoelectric conversion diodes 310, 320, and 330 are included in the first sensor pixel S1, the second sensor pixel S2, and the third sensor pixel S3, respectively.

The substrate 110 may be a light transmitting substrate, for example, a glass substrate or a polymer substrate. The polymer substrate may include, for example, polycarbonate, polymethylmethacrylate, polyethyleneterephthalate, polyethylenenaphthalate, polyimide, polyamide, polyamideimide, polyethersulfone, polyorganosiloxane, styrene-ethylene-butylene-styrene, polyurethane, polyacryl, polyolefin, or a combination thereof, but is not limited thereto.

A plurality of thin film transistors 120 are formed on the substrate 110. One or more thin film transistors 120 may be included in each of the first, second, and third subpixels PX1, PX2, and PX3 and the first, second, and third sensor pixels S1, S2, and S3 and may include, for example, at least one switching thin film transistor and/or at least one driving thin film transistor. The thin film transistor 120 includes a subpixel thin film transistor 120a for driving the first, second and third subpixels PX1, PX2, and PX3 and a sensor pixel thin film transistor 120b for driving the first, second, and third sensor pixels S1, S2, and S3. Accordingly, the first, second, and third subpixels PX1, PX2, and PX3 and the first, second, and third sensor pixels S1, S2, and S3 may be independently driven by corresponding ones of the subpixel thin film transistors 120a and the sensor pixel thin film transistors 120b, respectively. The substrate 110 on which the thin film transistor 120 is formed may be referred to as a thin film transistor substrate (TFT substrate) or a thin film transistor backplane (TFT backplane).

The insulation layer 140 may cover the substrate 110 and the thin film transistor 120 and may be formed on the entire surface of the substrate 110. The insulation layer 140 may be a planarization layer or a passivation layer, and may include an organic insulating material, an inorganic insulating material, an organic-inorganic insulating material, or any combination thereof. The insulation layer 140 may have a plurality of contact holes 141 for connecting the first, second, and third light emitting diodes 210, 220, and 230 and the subpixel thin film transistor 120a, and a plurality of contact holes 142 for electrically connecting the third organic photoelectric conversion diodes 310, 320, and 330 and the sensor pixel thin film transistor 120b.

The first, second, and third light emitting diodes 210, 220, and 230 are formed on the substrate 110 (or thin film transistor substrate) and are repeatedly arranged along the in-plane direction (e.g., xy direction) of the substrate 110. A pixel definition layer (not shown) may be between an adjacent pair of the first, second, and third light emitting diodes 210, 220, and 230, and thus each of the first, second, and third light emitting diodes 210, 220, and 230 may be partitioned by the pixel definition layer. The first, second, and third light emitting diodes 210, 220, and 230 may be included in the first subpixel PX1, the second subpixel PX2, and the third subpixel PX3, respectively. Each of the first, second and third light emitting diodes 210, 220, and 230 may be electrically connected to a separate subpixel thin film transistor 120a and driven independently.

The first, second, and third light emitting diodes 210, 220, and 230 are configured to emit light of different wavelength spectra from each other in the visible light wavelength spectrum. For example, the first light emitting diode 210 is configured to emit light of a first wavelength spectrum corresponding to a first color, the second light emitting diode 220 is configured to emit light of a second wavelength spectrum corresponding to a second color, and the third light emitting diode 230 is configured to emit light of a third wavelength spectrum corresponding to a third color. The first color, the second color, and the third color may be, for example, blue, green, and red, respectively, so that the first light emitting diode 210 may be configured to emit light in a blue wavelength spectrum, the second light emitting diode 220 may be configured to emit light of a green wavelength spectrum, and the third light emitting diode 230 may be configured to emit light of a red wavelength spectrum. Herein, the blue wavelength spectrum, the green wavelength spectrum, and the red wavelength spectrum may have a peak emission wavelength (λ_{peak,L}) in a wavelength region of greater than or equal to about 380 nm and less than about 500 nm, about 500 nm to about 600 nm, and greater than about 600 nm and less than about 750 nm, respectively.

The first, second, and third light emitting diodes 210, 220, and 230 may be, for example, an organic light emitting diode including an organic light emitting material, an inorganic light emitting diode including an inorganic light emitting material, a quantum dot light emitting diode including quantum dots, or a perovskite light emitting diode including a perovskite. For example, the first, second and third light emitting diodes 210, 220, and 230 may be organic light emitting diodes.

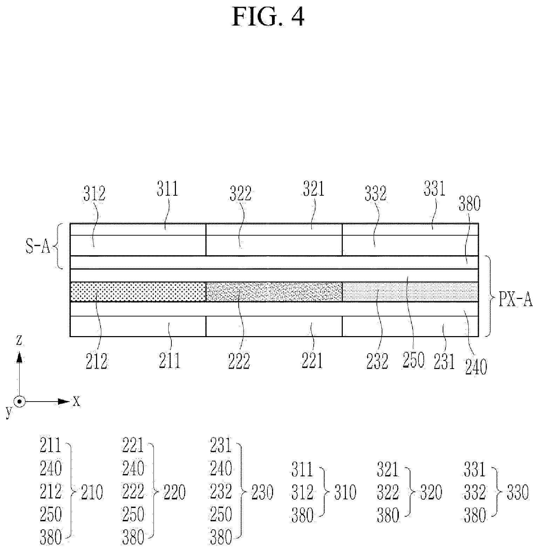

Referring to FIG. 4, the first, second, and third light emitting diodes 210, 220, and 230 include pixel electrodes 211, 221, and 231 for the first, second, and third light emitting diodes, a common electrode 380 facing the pixel electrodes 211, 221, and 231 for the first, second and third light emitting diodes, first, second, and third light emitting layers 212, 222, and 232 between the pixel electrodes 211, 221, and 231 for the first, second, and third light-emitting diodes and the common electrode 380, a first common auxiliary layer 240, and a second common auxiliary layer 250.

The pixel electrodes 211, 221, and 231 for the first, second, and third light emitting diodes are electrodes for applying individual voltages to the first, second, and third light emitting diodes 210, 220, and 230, and are separated from each other. The common electrode 380 is an electrode that applies a common voltage to the first, second, and third light emitting diodes 210, 220, and 230 and is formed on the entire surface of the substrate 110, and as will be described later, it may be shared with the first, second and third organic photoelectric conversion diodes of the pixel S. One of the pixel electrodes 211, 221, and 231 for the first, second, and third light emitting diodes or the common electrode 380 may be an anode and the other may be a cathode. For example, the pixel electrodes 211, 221, and 231 for the first, second, and third light emitting diodes may be an anode and the common electrode 380 may be a cathode.

The pixel electrodes 211, 221, and 231 for the first, second, and third light emitting diodes may be, for example, a light transmitting electrode or a reflective electrode, and the common electrode 380 may be, for example, a light transmitting electrode.

The light transmitting electrode may be a transparent electrode or a semi-transmissive electrode. The transparent electrode may have a light transmittance of about 85% to about 100%, about 90% to about 100%, or about 95% to about 100% and the semi-transmissive electrode may have a light transmittance of greater than or equal to about 30% and less than about 85%, about 40% to about 80%, or about 40% to about 75%. Here, the light transmittance may be an average light transmittance in the visible light wavelength spectrum (e.g., greater than or equal to about 380 nm and less than about 750 nm). The transparent electrode and the semi-transmissive electrode may include, for example, at least one of an oxide conductor, a carbon conductor, or a metal thin film. The oxide conductors may include, for example, one or more of indium tin oxide (ITO), indium zinc oxide (IZO), zinc tin oxide (ZTO), aluminum tin oxide (ATO), or aluminum zinc oxide (AZO), the carbon conductor may include one or more selected from graphene and carbon nanostructures, and the metal thin film may be a very thin (e.g. about 2 nm to 50 nm-thick) film including aluminum (Al), magnesium (Mg), silver (Ag), gold (Au), magnesium-silver (Mg-Ag), magnesium-aluminum (Mg-Al), an alloy thereof, or any combination thereof.

The reflective electrode may ideally include a reflective layer configured to reflect all light, and the reflective layer may have, for example, a light transmittance of 0 to about 5% and/or a reflectance of about 80% to about 100%. Here, the light transmittance and reflectance may be average light transmittance and average reflectance in the visible light wavelength spectrum (e.g., greater than or equal to about 380 nm and less than about 750 nm). The reflective electrode may include an optically opaque material and may include, for example, metal, metal nitride, or any combination thereof, for example, silver (Ag), copper (Cu), aluminum (Al), gold (Au), titanium (Ti), chromium (Cr), nickel (Ni), an alloy thereof, a nitride thereof (e.g., TiN), or any combination thereof, but is not limited thereto. The reflective electrode may be formed of a reflective layer or may have a stacked structure of a reflective layer/transmissive layer or a transmissive layer/reflective layer/transmissive layer, and the reflective layer may be one layer or two or more layers.

For example, the pixel electrodes 211, 221, and 231 for the first, second, and third light emitting diodes may be reflective electrodes, and the common electrode 380 may be a semi-transmissive electrode.

The first, second, and third light emitting layer 212, 222, and 232 may be between the pixel electrodes 211, 221, and 231 for the first, second, and third light emitting diodes and the common electrode 380, and may be configured to emit light of first, second, and third wavelength spectra that are different from each other, in the visible light wavelength spectrum. For example, when the first, second, and third light emitting diodes 210, 220, and 230 are a blue light emitting diode, a green light emitting diode, and a red light emitting diode, respectively. In other words, the first light emitting layer 212 included in the first light emitting diode 210 may be a blue light emitting layer configured to emit light in a blue wavelength spectrum, the second light emitting layer 222 included in the second light emitting diode 220 may be a green light emitting layer configured to emit light of a green wavelength spectrum, and the third light emitting layer 232 included in the third light emitting diode 230 may be a red light emitting layer configured to emit light of a red wavelength spectrum. Herein, the blue wavelength spectrum, the green wavelength spectrum, and the red wavelength spectrum may have a peak emission wavelength (λ_{peak,L}) in each wavelength spectrum of greater than or equal to about 380 nm and less than about 500 nm, about 500 nm to about 600 nm, and greater than about 600 nm and less than about 750 nm.

The first, second, and third light emitting layers 212, 222, and 232 may include an organic light emitting material, quantum dots, perovskite, or any combination thereof as a light emitting material. For example, the first, second, and third light emitting layers 212, 222, and 232 may include an organic light emitting material, and may include at least one host material and a fluorescent or phosphorescent dopant.

The organic light emitting material may be, for example, perylene; rubrene; 4-(dicyanomethylene)-2-methyl-6-[p-(dimethylamino)styryl]-4H-pyran; coumarin or a derivative thereof; carbazole or a derivative thereof; TPBi (2,2',2"-(1,3,5-benzinetriyl)-tris(1-phenyl-1-H-benzimidazole); TBADN (2-t-butyl-9,10-di(naphth-2-yl)anthracene); AND (9,10-di(naphthalene-2-yl)anthracene); CBP (4,4'-bis(N-carbazolyl)-1,1'-biphenyl); TCTA (4,4',4"-tris(carbazol-9-yl)-triphenylamine); TPBi (1,3,5-tris(N-phenylbenzimidazole-2-yl)benzene); TBADN (3-tert-butyl-9,10-di(naphth-2-yl)anthracene); DSA (distyrylarylene); CDBP (4,4'-bis(9-carbazolyl)2,2'-dimethylbiphenyl); MADN (2-Methyl-9,10-bis(naphthalen-2-yl)anthracene); TCP (1,3,5-tris(carbazol-9-yl)benzene); Alq3 (tris(8-hydroxyquinolino)lithium); an organometallic compound including Pt, Os, Ti, Zr, Hf, Eu, Tb, Tm, Rh, Ru, Re, Be, Mg, Al, Ca, Mn, Co, Cu, Zn, Ga, Ge, Pd, Ag and/or Au, a derivative thereof, or any combination thereof, but is not limited thereto.

The quantum dot may include, for example, a Group II-VI semiconductor compound, a Group III-V semiconductor compound, a Group IV-VI semiconductor compound, a Group IV semiconductor compound, a Group I-III-VI semiconductor compound, a Group I-II-IV-VI semiconductor compound, a Group II-III-V semiconductor compound, or any combination thereof. The Group II-IV semiconductor compound may be, for example, selected from a binary element semiconductor compound selected from CdSe, CdTe, ZnS, ZnSe, ZnTe, ZnO, HgS, HgSe, HgTe, MgSe, MgS, or a mixture thereof; a ternary element semiconductor compound selected from CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, or a mixture thereof; and a quaternary element semiconductor compound selected from HgZnTeS, CdZnSeS, CdZnSeTe, CdZnSTe, CdHgSeS, CdHgSeTe, CdHgSTe, HgZnSeS, HgZnSeTe, HgZnSTe, or a mixture thereof, but is not limited thereto. The Group III-V semiconductor compound may be, for example, selected from a binary element semiconductor compound selected from GaN, GaP, GaAs, GaSb, AIN, AlP, AlAs, AlSb, InN, InP, InAs, InSb, or a mixture thereof; a ternary element semiconductor compound selected from GaNP, GaNAs, GaNSb, GaPAs, GaPSb, AlNP, AlNAs, AlNSb, AlPAs, AlPSb, InNP, InNAs, InNSb, InPAs, InPSb, or a mixture thereof; and a quaternary element semiconductor compound selected from GaAlNP, GaAINAs, GaAINSb, GaAlPAs, GaAlPSb, GaInNP, GaInNAs, GaInNSb, GaInPAs, GaInPSb, InAlNP, InAINAs, InAlNSb, InAlPAs, InAlPSb, or a mixture thereof, but is not limited thereto. The Group IV-VI semiconductor compound may be, for example, selected from a binary element semiconductor compound selected from SnS, SnSe, SnTe, PbS, PbSe, PbTe, or a mixture thereof; a ternary element semiconductor compound selected from SnSeS, SnSeTe, SnSTe, PbSeS, PbSeTe, PbSTe, SnPbS, SnPbSe, SnPbTe, or a mixture thereof; and a quaternary element semiconductor compound selected from SnPbSSe, SnPbSeTe, SnPbSTe, or a mixture thereof, but is not limited thereto. The Group IV semiconductor may be, for example, selected from a single-element semiconductor compound such as Si, Ge, or a mixture thereof and a binary element compound selected from SiC, SiGe, or a mixture thereof, but is not limited thereto. The Group I-III-VI semiconductor compound may be, for example, CuInSe₂, CuInS₂, CuInGaSe, CuInGaS, or a mixture thereof, but is not limited thereto. The Group I-II-IV-VI semiconductor compound may be, for example, CuZnSnSe, CuZnSnS, or a mixture thereof, but is not limited thereto. The Group II-III-V semiconductor compound may be, for example, InZnP, but is not limited thereto.

The perovskite may be CH₃NH₃PbBr₃, CH₃NH₃Pbl₃, CH₃NH₃SnBr₃, CH₃NH₃SnI₃, CH₃NH₃Sn₁ₓPbₓBr₃(0<x<1), CH₃NH₃Sn₁ₓPbₓI₃, HC(NH₂)₂PbI₃, HC(NH₂)₂SnI₃, (C₄H₉NH₃)₂PbBr₄, (C₆H₅CH₂NH₃)₂PbBr₄, (C₆H₅CH₂NH₃)₂Pbl₄, (C₆H₅C₂H₄NH₃)₂PbBr₄, (C₆H₁₃NH₃)₂(CH₃NH₃)ₙ₁PbₙI₃ₙ₊₁ (n is a natural number) or any combination thereof, but is not limited thereto.

For example, the thicknesses of the first, second, and third light emitting layers 212, 222, and 232 may be the same as or different from each other. For example, when the pixel electrodes 211, 221, and 231 for the first, second, and third light emitting diodes are reflective electrodes and the common electrode 380 is a semi-transmissive electrode, the first, second, and third light emitting diodes 210, 220, and 230 may form a microcavity structure. Among the lights of the first, second, and third wavelength spectra emitted from the first, second, and third light emitting layers 212, 222, and 232, the light of the wavelength spectrum corresponding to the resonance wavelength of the microcavity may be intensified to exhibit amplified luminous characteristics in a narrow wavelength region. At this time, because the resonance wavelength of the microcavity may be determined according to the optical path length, which is a distance between the reflective electrode and the semi-transmissive electrode, when the thicknesses of the first common auxiliary layer 240 and the second common auxiliary layer 250 are assumed to be constant, the resonance wavelength of the microcavity may be determined according to the thickness of the first, second and third light emitting layers 212, 222 and 232.

For example, when the first, second, and third light emitting layers 212, 222, and 232 are a blue light emitting layer, a green light emitting layer, and a red light emitting layer, respectively, in order for the first, second, and third light emitting layers 212, 222, and 232 to have resonance wavelengths belonging to the blue wavelength spectrum, the green wavelength spectrum, and the red wavelength spectrum, respectively, a thickness of the blue light emitting layer may be the thinnest, a thickness of the red light emitting layer may be the thickest, and a thickness of the green light emitting layer may be between the thickness of the blue light emitting layer and the thickness of the red light emitting layer. Due to such a microcavity structure, the first, second, and third light emitting diodes 210, 220, and 230 may exhibit a relatively narrow emission spectrum and thus express colors of high color purity.

The first common auxiliary layer 240 and the second common auxiliary layer 250 may be formed on the entire surface of the substrate 110, the first common auxiliary layer 240 may be commonly formed between the pixel electrodes 211, 221, and 231 for the first, second, and third light emitting diodes and the first, second, and third light emitting layers 212, 222, and 232, and the second common auxiliary layer 250 may be commonly formed between the common electrode 380 and the first, second, and third light emitting layers 212, 222, and 232.

The first common auxiliary layer 240 may be a charge auxiliary layer (e.g., hole auxiliary layer) that facilitates injection and/or transfer of electric charges (e.g., holes) from the pixel electrodes 211, 221, and 231 for the first, second, and third light emitting diodes to the first, second, and third light emitting layers 212, 222, and 232.

For example, a HOMO energy level of the first common auxiliary layer 240 may be between HOMO energy levels of the first, second, and third light emitting layers 212, 222, and 232 and work functions of the pixel electrodes 211, 221, and 231 for the first, second, and third light emitting diodes. The work functions of the pixel electrodes 211, 221, and 231 for the first, second, and third light emitting diodes, the HOMO energy level of the first common auxiliary layer 240, and the HOMO energy levels of the first, second, and third light emitting layers 212, 222, and 232 may sequentially become deep.

The first common auxiliary layer 240 may include an organic material, an inorganic material, an organic-inorganic material, or any combination thereof satisfying the HOMO energy level, for example, a phthalocyanine compound such as copper phthalocyanine; DNTPD (N,N'-diphenyl-N,N'-bis-[4-(phenyl-m-tolyl-amino)-phenyl]-biphenyl-4,4'-diamine), m-MTDATA (4,4',4"-[tris(3-methylphenyl)phenylamino] triphenylamine), TDATA (4,4'4"-tris(N,N-diphenylamino)triphenylamine), 2-TNATA (4,4',4"-tris{N-(2-naphthyl)-N-phenylamino}-triphenylamine), PEDOT/PSS (poly(3,4-ethylenedioxythiophene)/poly(4-styrenesulfonate)), PANI/DBSA (polyaniline/dodecylbenzenesulfonic acid), PANI/CSA (polyaniline/Camphor sulfonic acid), PANI/PSS (polyaniline/poly(4-styrenesulfonate)), NPB (N,N'-di(naphthalene-1-yl)-N,N'-diphenylbenzidine), polyetherketone including triphenylamine (TPAPEK), 4-isopropyl-4'-methyldiphenyliodonium[tetrakis(pentafluorophenyl)borate], HAT-CN (dipyrazino[2,3-f: 2',3'-h] quinoxaline-2,3,6,7,10,11-hexacarbonitrile), a carbazole-based derivative such as N-phenylcarbazole, polyvinylcarbazole, and the like, a fluorene-based derivative, TPD (N,N'-bis(3-methylphenyl)-N,N'-diphenyl-[1,1-biphenyl]-4,4'-diamine), a triphenylamine-based derivative such as TCTA (4,4',4"-tris(N-carbazolyl)triphenylamine), NPB (N,N'-di(naphthalene-I-yl)-N,N'-diphenyl-benzidine), TAPC (4,4'-cyclohexylidene bis[N,N-bis(4-methylphenyl)benzenamine]), HMTPD (4,4'-bis[N,N'-(3-tolyl)amino]-3,3'-dimethylbiphenyl), mCP (1,3-bis(N-carbazolyl)benzene), or a combination thereof, but is not limited thereto. The first common auxiliary layer 240 may be one layer or two or more layers.

The second common auxiliary layer 250 may be a charge auxiliary layer (e.g., electron auxiliary layer) that facilitates injection and/or transfer of electric charges (e.g., electrons) from the common electrode 380 to the first, second, and third light emitting layers 212, 222, and 232. For example, the LUMO energy level of the second common auxiliary layer 250 may be between the LUMO energy levels of the first, second, and third light emitting layers 212, 222, and 232 and the work function of the common electrode 380. The work function of the common electrode 380, the LUMO energy levels of the second common auxiliary layer 250, and the LUMO energy levels of the first, second, and third light emitting layers 212, 222, and 232 may sequentially become shallow.

The second common auxiliary layer 250 may include an organic material, an inorganic material, an organic-inorganic material, or a combination thereof satisfying the LUMO energy level, for example a halogenated metal such as LiF, NaCl, CsF, RbCl, and Rbl; a lanthanides metal such as Yb; a metal oxide such as Li₂O or BaO; Liq (lithium quinolate), Alq3 (tris(8-hydroxyquinolinato)aluminum), 1,3,5-tri[(3-pyridyl)-phen-3-yl]benzene, 2,4,6-tris (3'-(pyridin-3-yl)biphenyl-3-yl)-1,3,5-triazine, 2-(4-(N-phenylbenzoimidazolyl-1-ylphenyl)-9,10-dinaphthylanthracene, TPBi (1,3,5-tri(1-phenyl-1H-benzo[d]imidazol-2-yl)phenyl), BCP (2,9-dimethyl-4,7-diphenyl-1,10-phenanthroline), Bphen (4,7-diphenyl-1,10-phenanthroline), TAZ (3-(4-biphenylyl)-4-phenyl-5-tertbutylphenyl-1,2,4-triazole), NTAZ (4-(naphthalen-1-yl)-3,5-diphenyl-4H-1,2,4-triazole), tBu-PBD (2-(4-biphenylyl)-5-(4-tert-butylphenyl)-1,3,4-oxadiazole), BAlq (bis(2-methyl-8-quinolinolato-N1,O8)-(1,1'-biphenyl-4-olato)aluminum), Bebq₂ (berylliumbis(benzoquinolin-10-olate), ADN (9,10-di(naphthalene-2-yl)anthracene), BmPyPhB (1,3-bis[3,5-di(pyridin-3-yl)phenyl]benzene), or a combination thereof, but is not limited thereto. The second common auxiliary layer 250 may be one layer or two or more layers.

The first, second, and third organic photoelectric conversion diodes 310, 320, and 330 overlap the first, second, and third light emitting diodes 210, 220, and 230, respectively along the thickness direction (e.g., z direction) of the substrate 110 and are repeatedly arranged on corresponding ones of the first, second, and third light emitting diodes 210, 220, and 230, along the in-plane direction (e.g., xy direction) of the substrate 110. A pixel definition layer (not shown) may be between the adjacent first, second, and third organic photoelectric conversion diodes 310, 320, and 330, and each of the first, second, and third organic photoelectric conversion diodes 310, 320, and 330 may be partitioned by the pixel definition layer. The first, second, and third organic photoelectric conversion diodes 310, 320, and 330 may be included in the first sensor pixel S1, the second sensor pixel S2, and the third sensor pixel S3, respectively. Each of the first, second and third sensor pixels S1 may be electrically connected to a separate sensor pixel thin film transistor 120b and driven independently.

The first, second, and third organic photoelectric conversion diodes 310, 320, and 330 may be configured to selectively absorb light of a first partial wavelength spectrum belonging to (e.g., within) the visible light wavelength spectrum and convert the absorbed light into an electrical signal. The first, second, and third organic photoelectric conversion diodes 310, 320, and 330 are configured to transmit light of a second partial wavelength spectrum belonging to (e.g., within) the visible light wavelength spectrum.

The first organic photoelectric conversion diode 310 may be on the first light emitting diode 210 to transmit light of a first wavelength spectrum emitted from the first light emitting diode 210, and it may be configured to selectively absorb light of the second and third wavelength spectra other than the first wavelength spectrum among the visible light wavelength spectrum, and to convert the absorbed light into an electrical signal. For example, when the first, second, and third wavelength spectra are blue, green, and red wavelength spectra, respectively, the first organic photoelectric conversion diode 310 may be configured to transmit light of the blue wavelength spectrum emitted from the first light emitting diode 210, and may be configured to selectively absorb light in the green to red wavelength spectra, and convert the absorbed light into an electrical signal.

In this case, a full width at half maximum (FWHM) of the first wavelength spectrum transmitted through the first organic photoelectric conversion diode 310 may be smaller than a FWHM of the first wavelength spectrum emitted from the first light emitting diode 210. Herein, the FWHM is a width of the wavelength corresponding to half of the emission intensity at the peak emission wavelength (λ_{peak,L}) in the wavelength spectrum (e.g., the emission spectrum according to the wavelength), and a narrow FWHM means high wavelength selectivity. Accordingly, the first color displayed in the first subpixel PX1 of the display panel 1000 may have a narrower wavelength region than the light emitted from the first light emitting diode 210, and thus it is possible to improve display quality by increasing color purity of the first color of the display panel 1000. Accordingly, the first organic photoelectric conversion diode 310 may modify the light of the first wavelength spectrum emitted from the first light emitting diode 210 into light having a narrower FWHM on the first light emitting diode 210 to serve as a color filter for increasing color purity.

Similarly, the second organic photoelectric conversion diode 320 is on the second light emitting diode 220 to transmit light of a second wavelength spectrum emitted from the second light emitting diode 220, and it may be configured to selectively absorb light of the first and third wavelength spectra other than the second wavelength spectrum among the visible light wavelength spectrum and convert the absorbed light into an electrical signal. For example, when the first, second, and third wavelength spectra are blue, green, and red wavelength spectra, respectively, the second organic photoelectric conversion diode 320 may be configured to transmit light of the green wavelength spectrum emitted from the second light emitting diode 220, selectively absorb light in the blue and red wavelength spectra, and convert the absorbed light into an electrical signal.

In this case, a FWHM of the second wavelength spectrum transmitted through the second organic photoelectric conversion diode 320 may be smaller than a FWHM of the second wavelength spectrum emitted from the second light emitting diode 220. Accordingly, the second color displayed in the second subpixel PX2 of the display panel 1000 may have a narrower wavelength region than the light emitted from the second light emitting diode 220, and thus it is possible to improve display quality by increasing color purity of the second color of the display panel 1000. Accordingly, the second organic photoelectric conversion diode 320 may modify the light of the second wavelength spectrum emitted from the second light emitting diode 220 into light having a narrower FWHM on the second light emitting diode 220 to serve as a color filter for increasing color purity.

Similarly, the third organic photoelectric conversion diode 330 is on the third light emitting diode 230 to transmit light of a third wavelength spectrum emitted from the third light emitting diode 230, and it may be configured to selectively absorb the light of the first and second wavelength spectra other than the third wavelength spectrum, and convert the absorbed light into an electrical signal. For example, when the first, second, and third wavelength spectra are blue, green, and red wavelength spectra, respectively, the third organic photoelectric conversion diode 330 may be configured to transmit light of the red wavelength spectrum emitted from the third light emitting diode 230, selectively absorb light in the blue to green wavelength spectra, and convert the absorbed light into an electrical signal.

Herein, a FWHM of the third wavelength spectrum transmitted through the third organic photoelectric conversion diode 330 may be narrower than a FWHM of the third wavelength spectrum emitted from the third light emitting diode 230. Accordingly, the third color displayed in the third subpixel PX3 of the display panel 1000 may have a narrower wavelength region than the light emitted from the third light emitting diode 230, and thus it is possible to improve display quality by increasing color purity of the third color of the display panel 1000. Accordingly, the third organic photoelectric conversion diode 330 may modify the light of the third wavelength spectrum emitted from the third light emitting diode 230 into light having a narrower FWHM on the third light emitting diode 230 to serve as a color filter for increasing color purity.

Meanwhile, as described above, the first, second, and third organic photoelectric conversion diodes 310 may be configured to absorb a portion of the light of the visible light wavelength spectrum and convert the absorbed light into an electrical signal. That is, the first organic photoelectric conversion diode 310 may be configured to selectively absorb light of the second and third wavelength spectra of the visible light wavelength spectrum and convert the absorbed light into an electrical signal, the second organic photoelectric conversion diode 320 may be configured to selectively absorb light of the first and third wavelength spectra of the visible light wavelength spectrum and convert the absorbed light into an electrical signal, and the third organic photoelectric conversion diode 330 may be configured to selectively absorb light of first and second wavelength spectra of the visible light wavelength spectrum and convert the absorbed light into an electrical signal.

Using these photoelectric conversion characteristics, the first, second, and third organic photoelectric conversion diodes 310, 320, and 330 may be used as an optical recognition sensor (e.g., a biometric sensor) and light emitted from any one of the third light emitting diodes 210, 220, and 230 and reflected by a recognition target 40 such as a living body, a tool, or an object on the surface of the display panel 1000 may be effectively absorbed and converted into an electrical signal, and thereby a biometric recognition function may be performed. Herein, the living body may be a finger, a fingerprint, a palm, an iris, a face, and/or a wrist, but is not limited thereto.

For example, light of a first wavelength spectrum (e.g., a blue spectrum) emitted from the first light emitting diode 210, passed through the first organic photoelectric conversion diode 310, and reflected by the recognition target 40 may be absorbed by at least one of the second organic photoelectric conversion diode 320 or the third organic photoelectric conversion diode 330, and converted into an electrical signal to sense the recognition target 40.

For example, light of a second wavelength spectrum (e.g., a green spectrum) emitted from the second light emitting diode 220, passed through the second organic photoelectric conversion diode 320, and reflected by the recognition target 40 may be absorbed by at least one of the first organic photoelectric conversion diode 310 or the third organic photoelectric conversion diode 330 and converted into an electrical signal to sense the recognition target 40.

For example, light of a third wavelength spectrum (e.g., a red spectrum) emitted from the third light emitting diode 230, passed through the second organic photoelectric conversion diode 330, and reflected by the recognition target 40 may be absorbed by at least one of the first organic photoelectric conversion diode 310 or the second organic photoelectric conversion diode 320 and converted into an electrical signal to sense the recognition target 40.

Ultimately, the display panel 1000 may improve a display quality by increasing the color purity of all colors displayed on the display panel 1000 without a separate color filter, and at the same time, the first, second, and third organic photoelectric conversion diodes 310, 320, and 330 may be used to implement an optical recognition sensor (e.g., a biometric sensor).

Referring to FIG. 4, the first, second, and third organic photoelectric conversion diodes 310, 320, and 330 may include a common electrode 380; pixel electrodes 311, 321, and 331 for first, second, and third organic photoelectric conversion diodes facing the common electrode 380; and the first, second, and third organic photoelectric conversion layers 312, 322, and 332 between the common electrode 380 and the pixel electrodes 311, 321, and 331 for the first, second, and third organic photoelectric conversion diodes.

The common electrode 380 is an electrode for applying a common voltage to the first, second, and third organic photoelectric conversion diodes 310, 320, and 330, and may be shared with the aforementioned first, second, and third light emitting diodes 210, 220, and 230. However, the common electrode of the first, second, and third organic photoelectric conversion diodes 310, 320, and 330 is not limited thereto, and a plurality of common electrodes of the first, second, and third light emitting diodes 210, 220, and 230 may be provided to be separate from each other.

The pixel electrodes 311, 321, and 331 for the first, second, and third organic photoelectric conversion diodes are electrodes for applying individual voltages to the first, second, and third organic photoelectric conversion diodes 310, 320, and 330, and are separated from each other. The pixel electrodes 311, 321, and 331 for the first, second, and third organic photoelectric conversion diodes may be electrically connected to the sensor pixel thin film transistor 120b through the contact hole 142, but the present disclosure is not limited thereto and the pixel electrodes 311, 321, and 331 for the first, second, and third organic photoelectric conversion diodes and the sensor pixel thin film transistor 120b may be electrically connected with various designs. The pixel electrodes 311, 321, and 331 for the first, second, and third organic photoelectric conversion diodes are included as upper electrodes of the first, second, and third organic photoelectric conversion diodes 310, 320, and 330, and thus they may be formed in a method capable of reducing or preventing damage to lower layers such as the first, second, and third organic photoelectric conversion layers 312, 322, and 332, and may be formed, for example, by deposition using a shadow mask.

One of the pixel electrodes 311, 321, and 331 for the first, second, and third organic photoelectric conversion diodes or the common electrode 380 may be an anode and the other may be a cathode. For example, the pixel electrodes 311, 321, and 331 for the first, second, and third organic photoelectric conversion diodes may be anodes and the common electrode 380 may be a cathode.

The pixel electrodes 311, 321, and 331 for the first, second, and third organic photoelectric conversion diodes and the common electrode 380 may each be a light transmitting electrode, and the light transmitting electrode is the same as described above. The pixel electrodes 311, 321, and 331 for the first, second, and third organic photoelectric conversion diodes may be incident electrodes or light receiving electrodes that transmit light into the display panel 1000.

The first, second and third organic photoelectric conversion layers 312, 322 and 332 may be between the pixel electrodes 311, 321 and 331 for the first, second and third organic photoelectric conversion diodes and the common electrode 380, and may be configured to selectively absorb light of partial wavelength belonging to the visible light wavelength spectrum and convert the absorbed light into an electrical signal.

The first, second, and third organic photoelectric conversion layers 312, 322, and 332 each may include a p-type semiconductor and an n-type semiconductor capable of forming a pn junction, and at least one of the p-type semiconductor or the n-type semiconductor may be an organic photoelectric conversion material configured to selectively absorb light of partial wavelength belonging to the visible light wavelength spectrum.

For example, the first organic photoelectric conversion layer 312 overlapping the first light emitting diode 210 configured to emit light of the first wavelength spectrum may include an organic photoelectric conversion material configured to absorb (e.g., capable of absorbing) light of the second and third wavelength spectra among the visible light wavelength spectrum or a combination of an organic photoelectric conversion material configured to selectively absorb (e.g., capable of selectively absorbing) light of the second wavelength spectrum and an organic photoelectric conversion material configured to selectively absorb (e.g., capable of selectively absorbing) light of the third wavelength spectrum. Herein, the combination may be a mixture or a stack structure.

For example, when the first, second, and third wavelength spectra are blue, green, and red wavelength spectra, respectively, the first organic photoelectric conversion layer 312 may include an organic photoelectric conversion material having light absorption characteristics over a wavelength spectrum of about 500 nm to about 750 nm; a mixture of an organic photoelectric conversion material having a peak absorption wavelength (λ_{peak,A}) in the wavelength spectrum of about 500 nm to about 600 nm and an organic photoelectric conversion material having a peak absorption wavelength (λ_{peak,A}) in the wavelength spectrum greater than about 600 nm and about 750 nm; or a stack of a first layer including an organic photoelectric conversion material having a peak absorption wavelength (λ_{peak,A}) in a wavelength spectrum of about 500 nm to about 600 nm and a second layer including an organic photoelectric conversion material having a peak absorption wavelength (λ_{peak,A}) in a wavelength spectrum greater than about 600 nm and about 750 nm.

Similarly, the second organic photoelectric conversion layer 322 may include an organic photoelectric conversion material having a peak absorption wavelength (λ_{peak,A}) in a wavelength spectrum of greater than or equal to about 380 nm and less than about 500 nm and a wavelength spectrum of greater than about 600 nm and less than about 750 nm, respectively; a mixture of an organic photoelectric conversion material having a peak absorption wavelength (λ_{peak,A}) in the wavelength spectrum of greater than or equal to about 380 nm and less than about 500 nm and an organic photoelectric conversion material having a peak absorption wavelength (λ_{peak,A}) in the wavelength spectrum of greater than about 600 nm and less than about 750 nm; or a stack of a first layer including an organic photoelectric conversion material having a peak absorption wavelength (λ_{peak,A}) in a wavelength spectrum greater than or equal to about 380 nm and less than about 500 nm and a second layer including an organic photoelectric conversion material having a peak absorption wavelength (λ_{peak,A}) in a wavelength spectrum of greater than about 600 nm and less than about 750 nm.

Similarly, the third organic photoelectric conversion layer 332 may include an organic photoelectric conversion material having light absorption characteristics over a wavelength spectrum of about 380 nm to about 600 nm; a mixture of an organic photoelectric conversion material having a peak absorption wavelength (λ_{peak,A}) in a wavelength spectrum of greater than or equal to about 380 nm and less than about 500 nm and an organic photoelectric conversion material having a peak absorption wavelength (λ_{peak,A}) in the wavelength spectrum of about 500 nm to 600 nm; or a stack of a first layer including an organic photoelectric conversion material having a peak absorption wavelength (λ_{peak,A}) in the wavelength spectrum of greater than or equal to about 380 nm and less than about 500 nm and a second layer including an organic photoelectric conversion material having a peak absorption wavelength (λ_{peak,A}) in a wavelength spectrum of about 500 nm to about 600 nm.

Between the common electrode 380 and the first, second, and third organic photoelectric conversion layers 312, 322, and 332 and/or between the pixel electrodes 311, 321, and 331 for the first, second, and third organic photoelectric conversion diodes and the first, second, and third organic photoelectric conversion layers 312, 322, and 332, an auxiliary layer (not shown) may be further included. The auxiliary layer between the common electrode 380 and the first, second, and third organic photoelectric conversion layers 312, 322, and 332 may be a charge auxiliary layer (e.g., electron auxiliary layer) that facilitates injection and/or transfer of electric charges (e.g., electrons) from the first, second, and third organic photoelectric conversion layers 312, 322, and 332 to the common electrode 380. The auxiliary layer between the pixel electrodes 311, 321, and 331 for the first, second, and third organic photoelectric conversion diodes and the first, second, and third organic photoelectric conversion layers 312, 322, and 332 may be a charge auxiliary layer (e.g., hole auxiliary layer) that facilitates injection and/or transfer of electric charges (e.g., holes) from the first, second, and third organic photoelectric conversion layers 312, 322, and 332 into the pixel electrodes 311, 321, and 331 for the first, second, and third organic photoelectric conversion diodes. A specific material of the charge auxiliary layer is as described above. In the drawing, the common electrode 380 of the first, second, and third organic photoelectric conversion diodes 310, 320, and 330 is a lower electrode, and the pixel electrodes for first, second, and third organic photoelectric conversion diodes 311, 321, and 331 are upper electrodes, but the present disclosure is not limited thereto, and the pixel electrodes 311, 321, and 331 for the first, second, and third organic photoelectric conversion diodes 310, 320, and 330 may be lower electrodes and the common electrode 380 of the photoelectric conversion diodes 310, 320, and 330 may be an upper electrode.

An encapsulation layer 50 may be formed on the first, second, and third organic photoelectric conversion diodes 310, 320, and 330. The encapsulation layer 50 may include, for example, a glass plate, a metal thin film, an organic layer, an inorganic layer, an organic/inorganic layer, or a combination thereof. The organic layer may include, for example, an acrylic resin, a (meth)acrylic resin, polyisoprene, a vinyl resin, an epoxy resin, a urethane resin, a cellulose resin, a perylene resin, or a combination thereof, but is not limited thereto. The inorganic layer may include, for example, oxide, nitride, and/or oxynitride, for example, silicon oxide, silicon nitride, silicon oxynitride, aluminum oxide, aluminum nitride, aluminum oxynitride, zirconium oxide, zirconium nitride, zirconium oxynitride, titanium oxide, titanium nitride, titanium oxynitride, hafnium oxide, hafnium nitride, hafnium oxynitride, tantalum oxide, tantalum nitride, tantalum oxynitride, lithium fluoride, or any combination thereof, but is not limited thereto. The organic/inorganic layer may include, for example, polyorganosiloxane but is not limited thereto. The encapsulation layer 50 may have one layer or two or more layers.

As described above, the display panel 1000 according to some example embodiments includes first, second, and third light emitting diodes 210, 220, and 230 configured to emit light of a desired (or alternatively, predetermined) wavelength spectrum to display colors, and first, second, and/or third organic photoelectric conversion diodes 310, 320, and 330 configured to absorb the light reflected by the recognition target 40 and to convert the absorbed light into an electrical signal, thereby performing both a display function and a recognition function (e.g., a biometric recognition function).

In addition, because the first, second, and third organic photoelectric conversion diodes 310, 320, and 330 use light emitted from the first, second, and third light emitting diodes 210, 220, and 230, a recognition function (e.g., biometric recognition function) may be performed without a separate light source. Therefore, a separate light source inside or outside the display panel 1000 may not be needed, thereby preventing or mitigating a decrease in the aperture ratio of the display panel due to the area occupied by the light source, and at the same time saving power consumed by the separate light source to improve power consumption of the display panel 1000.

In addition, because the first, second, and third organic photoelectric conversion diodes 310, 320, and 330 include an organic photoelectric conversion material, they may have light absorption twice as high as compared to inorganic diodes such as silicon photodiodes to have a high-sensitivity sensing function with a thin thickness.

Also, the first, second, and third light emitting diodes 210, 220, and 230 are arranged with a high density in the entire surface of the display panel 1000, regardless of the first, second, and third organic photoelectric conversion diodes 310, 320, and 330 and thereby, a high aperture ratio of the display panel 2000 may be secured.

In addition, the first, second, and third organic photoelectric conversion diodes 310, 320, and 330 are stacked with the first, second, and third light emitting diodes 210, 220, and 230 to be arranged at high density without affecting the aperture ratio of the display panel 1000, and accordingly, a highly sensitive recognition sensor may be implemented. Accordingly, a biometric recognition function may be performed in all areas of a screen of an electronic device such as a mobile device.

In addition, as described above, the first, second, and third organic photoelectric conversion diodes 310, 320, and 330 are used as an optical recognition sensor (e.g., a biometric sensor), and perform the role of a color filter that modifies the light emitted from the first, second, and third light emitting diodes 210, 220, and 230 into light having a narrower FWHM, and thereby the color purity of all colors displayed on the display panel 1000 may be increased without a separate color filter to improve display quality. Also, because the display panel 1000 does not include a separate color filter, a manufacturing process may be simplified and a slim display panel may be realized.

The aforementioned display panel 2000 may be applied to electronic devices such as various display devices. Electronic devices such as display devices may be applied to, for example, mobile phones, video phones, smart phones, smart pads, smart watches, digital cameras, tablet PCs, laptop PCs, notebook computers, computer monitors, wearable computers, televisions, digital broadcasting terminals, e-books, personal digital assistants (PDAs), portable multimedia player (PMP), enterprise digital assistant (EDA), head mounted display (HMD), vehicle navigation, Internet of Things (IoT), Internet of all things (IoE), drones, door locks, safes, automatic teller machines (ATM), security devices, medical devices, or automotive electronic components, but are not limited thereto.

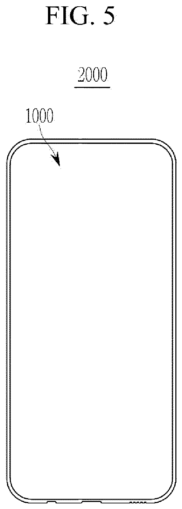

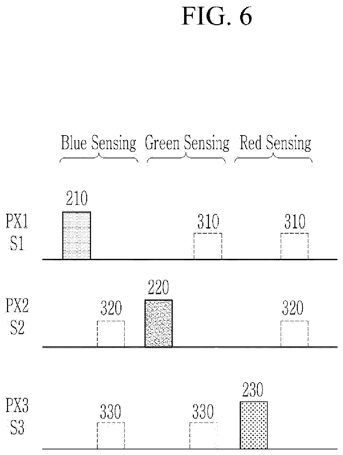

FIG. 5 is a schematic view illustrating an example of an electronic device according to an example embodiment, and FIG. 6 is a driving timing diagram illustrating an example embodiment of an operation method for performing a biometric recognition function of an electronic device according to an example embodiment.

Referring to FIG. 5, the electronic device 2000 includes the display panel 1000 described above, and the first, second, and third light emitting diodes 210, 220, and 230 and the first, second, and third organic photoelectric conversion diodes 310, 320, and 330 are arranged in the entire surface of the display panel 1000, and thereby the biometric function may be performed at any portion of the screen without deteriorating the aperture ratio.

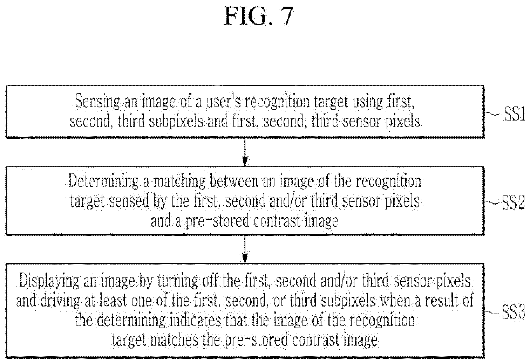

Referring to FIGS. 6 and 7, an example embodiment of an operating method for performing a biometric function of an electronic device 2000 may include sensing an image of a recognition target 40 of a user (first operation S1) by performing at least one of (1) driving the first subpixel PX1 (first light emitting diode 210) and driving the second sensor pixel S2 (second organic photoelectric conversion diode 320) and the third sensor pixel S3 (third organic photoelectric conversion diode 330) to sense light of the first wavelength spectrum (e.g., blue wavelength spectrum) corresponding to the first color (e.g., blue) reflected by the recognition target 40 of the user, through the second sensor pixel S2 and the third sensor pixel S3, (2) driving the second subpixel PX2 (second light emitting diode 220) and driving the first sensor pixel S1 (first organic photoelectric conversion diode 310) and the third sensor pixel S3 (third organic photoelectric conversion diode 330) to sense light of the light of a second wavelength spectrum (e.g., green wavelength spectrum) corresponding to the second color (e.g., green) reflected by the recognition target 40 of the user, through the first sensor pixel S1 and the third sensor pixel S3, or (3) driving the third subpixel (PX3, third light emitting diode 230) and driving the first sensor pixel (S1, first organic photoelectric conversion diode 310) and the second sensor pixel (S2, second organic photoelectric conversion diode 320) to sense light of the light of a third wavelength spectrum (e.g., red wavelength spectrum) corresponding to the third color (e.g., red) reflected by the recognition target 40 of the user, through the first sensor pixel S1 and the second sensor pixel S2. Herein, the first subpixel PX1, the second subpixel PX2, and/or the third subpixel PX3 may be driven under a forward bias, and the first sensor pixel S1, the second sensor pixel S2, and/or the third sensor pixel S3 may be driven under a reverse bias.

Additionally, the method may further include comparing a pre-stored contrast image with the image of the recognition target 40 sensed through the first, second, and/or third sensor pixels S1, S2, and S3 (second operation S2) and displaying an image by turning off the first, second and/or third sensor pixels S1, S2, and S3 and driving at least one of the first, second, and third subpixels PX1, PX2, and PX3 when the contrast image and the image of the recognition target 40 match each other (third operation S3). In other words, the method may further include determining a matching between the image of the recognition target 40 and the pre-stored contrast image (second operation S2) and displaying an image by turning off the first, second and/or third sensor pixels S1, S2, and S3 and driving at least one of the first, second, and third subpixels PX1, PX2, and PX3 when a result of the determining indicates that the image of the recognition target 40 matches the pre-stored contrast image (third operation S3).

While this disclosure has been described in connection with what is presently considered to be practical example embodiments, it is to be understood that the inventive concepts are not limited to the disclosed example embodiments. On the contrary, it is intended to cover various modifications and equivalent arrangements included within the scope of the appended claims.

## Claims

1. A display panel (1000), comprising
a substrate (110), first, second, and third light emitting diodes on the substrate, the first, second, and third light emitting diodes (210, 220, 230) being configured to emit light of first second, and third wavelength spectra, respectively, the first, second, and third wavelength spectra being different from each other in a visible light spectrum,
a first organic photoelectric conversion diode (310) overlapping the first light emitting diode (210) along a thickness direction of the substrate, the first organic photoelectric conversion diode being configured to selectively absorb light of the second and third wavelength spectra and convert the absorbed light of the second and third wavelength spectra into an electrical signal,
a second organic photoelectric conversion diode (320) overlapping the second light emitting diode (220) along the thickness direction of the substrate, the second organic photoelectric conversion diode being configured to selectively absorb light of the first and third wavelength spectra and convert the absorbed light of the first and third wavelength spectra into an electrical signal, and
a third organic photoelectric conversion diode (330) overlapping the third light emitting diode (230) along the thickness direction of the substrate, the third organic photoelectric conversion diode being configured to selectively absorb light of the first and second wavelength spectra and convert the absorbed light of the second and third wavelength spectra into an electrical signal.

2. The display panel of claim 1, wherein
the first, second, and third light emitting diodes are arranged in parallel along an in-plane direction of the substrate, and
the first, second, and third organic photoelectric conversion diodes are arranged in parallel along an in-plane direction of the substrate, the first, second, and third organic photoelectric conversion diodes being on the first, second, and third light emitting diodes, respectively.

3. The display panel of claim 1 or 2, wherein:
an area of the first organic photoelectric conversion diode is greater than or equal to an area of the first light emitting diode;
an area of the second organic photoelectric conversion diode is greater than or equal to an area of the second light emitting diode; and
an area of the third organic photoelectric conversion diode is greater than or equal to an area of the third light emitting diode.

4. The display panel of any preceding claim, wherein:
the first organic photoelectric conversion diode is configured to transmit light of the first wavelength spectrum emitted from the first light emitting diode;
a full width at half maximum (FWHM) of the first wavelength spectrum transmitted through the first organic photoelectric conversion diode is narrower than a FWHM of the first wavelength spectrum emitted from the first light emitting diode;
the second organic photoelectric conversion diode is configured to transmit light of the second wavelength spectrum emitted from the second light emitting diode;
a FWHM of the second wavelength spectrum transmitted through the second organic photoelectric conversion diode is narrower than a FWHM of the second wavelength spectrum emitted from the second light emitting diode;
the third organic photoelectric conversion diode is configured to transmit light of the third wavelength spectrum emitted from the third light emitting diode; and
a FWHM of the third wavelength spectrum transmitted through the third organic photoelectric conversion diode is narrower than a FWHM of the third wavelength spectrum emitted from the third light emitting diode.

5. The display panel of any preceding claim, wherein the first, second, and third light emitting diodes and the first, second, and third organic photoelectric conversion diodes share a common electrode for applying a common voltage to the first, second, and third light emitting diodes and the first, second, and third organic photoelectric conversion diodes.

6. The display panel of claim 5, wherein:
the first, second, and third light emitting diodes include first pixel electrodes for the first, second, and third light emitting diodes, the first pixel electrodes facing the common electrode and separated from each other;
the first, second, and third organic photoelectric conversion diodes include second pixel electrodes for first, second, and third organic photoelectric conversion diodes, the second pixel electrodes facing the common electrode and separated from each other; and
the first pixel electrodes and the second pixel electrodes are electrically connected to different thin film transistors from each other.

7. The display panel of any preceding claim, wherein:
the first organic photoelectric conversion diode includes: an organic photoelectric conversion material capable of selectively absorbing light of the second wavelength spectrum and the third wavelength spectrum; or a combination of an organic photoelectric conversion material capable of selectively absorbing light of the second wavelength spectrum and an organic photoelectric conversion material capable of selectively absorbing light of the third wavelength spectrum;
the second organic photoelectric conversion diode includes: an organic photoelectric conversion material capable of selectively absorbing light of the first wavelength spectrum and the third wavelength spectrum; or a combination of an organic photoelectric conversion material capable of selectively absorbing light of the first wavelength spectrum and an organic photoelectric conversion material capable of selectively absorbing light of the third wavelength spectrum; and
the third organic photoelectric conversion diode includes: an organic photoelectric conversion material capable of selectively absorbing light of the first wavelength spectrum and the second wavelength spectrum; or a combination of an organic photoelectric conversion material capable of selectively absorbing light of the first wavelength spectrum and an organic photoelectric conversion material capable of selectively absorbing light of the second wavelength spectrum.

8. The display panel of any preceding claim, wherein:
the first wavelength spectrum is a blue wavelength spectrum having a peak wavelength in a first wavelength spectrum of greater than or equal to 380 nm and less than 500 nm;
the second wavelength spectrum is a green wavelength spectrum having a peak wavelength in a second wavelength spectrum of 500 nm to 600 nm; and
the third wavelength spectrum is a red wavelength spectrum having a peak wavelength in a third wavelength spectrum of greater than 600 nm and less than 750 nm.

9. The display panel of any preceding claim, wherein:
at least one of the second organic photoelectric conversion diode or the third organic photoelectric conversion diode is configured to sense the light of the first wavelength spectrum emitted from the first light emitting diode and reflected by a recognition target;
at least one of the first organic photoelectric conversion diode or the third organic photoelectric conversion diode is configured to sense the light of the second wavelength spectrum emitted from the second light emitting diode and reflected by the recognition target; and
at least one of the first organic photoelectric conversion diode or the second organic photoelectric conversion diode is configured to sense the light of the third wavelength spectrum emitted from the third light emitting diode and reflected by the recognition target.

10. An electronic device comprising the display panel according to any preceding claim.

## Patentansprüche

1. Anzeigetafel (1000), umfassend
ein Substrat (110),
eine erste, eine zweite und eine dritte lichtemittierende Diode auf dem Substrat, wobei die erste, die zweite und die dritte lichtemittierende Diode (210, 220, 230) dazu konfiguriert sind, Licht eines ersten, eines zweiten beziehungsweise eines dritten Wellenlängenspektrums zu emittieren, wobei sich das erste, das zweite und das dritte Wellenlängenspektrum in einem sichtbaren Lichtspektrum voneinander unterscheiden,
eine erste organische photoelektrische Umwandlungsdiode (310), die die erste lichtemittierende Diode (210) entlang einer Dickenrichtung des Substrats überlappt, wobei die erste organische photoelektrische Umwandlungsdiode dazu konfiguriert ist, selektiv Licht des zweiten und des dritten Wellenlängenspektrums zu absorbieren und das absorbierte Licht des zweiten und des dritten Wellenlängenspektrums in ein elektrisches Signal umzuwandeln,
eine zweite organische photoelektrische Umwandlungsdiode (320), die die zweite lichtemittierende Diode (220) entlang der Dickenrichtung des Substrats überlappt, wobei die zweite organische photoelektrische Umwandlungsdiode dazu konfiguriert ist, selektiv Licht des ersten und des dritten Wellenlängenspektrums zu absorbieren und das absorbierte Licht des ersten und des dritten Wellenlängenspektrums in ein elektrisches Signal umzuwandeln, und
eine dritte organische photoelektrische Umwandlungsdiode (330), die die dritte lichtemittierende Diode (230) entlang der Dickenrichtung des Substrats überlappt, wobei die dritte organische photoelektrische Umwandlungsdiode dazu konfiguriert ist, selektiv Licht des ersten und des zweiten Wellenlängenspektrums zu absorbieren und das absorbierte Licht des zweiten und des dritten Wellenlängenspektrums in ein elektrisches Signal umzuwandeln.

2. Anzeigetafel nach Anspruch 1, wobei
die erste, die zweite und die dritte lichtemittierende Diode parallel entlang einer Richtung in der Ebene des Substrats angeordnet sind und
die erste, die zweite und die dritte organische photoelektrische Umwandlungsdiode parallel entlang einer Richtung in der Ebene des Substrats angeordnet sind, wobei sich die erste, die zweite und die dritte organische photoelektrische Umwandlungsdiode auf der ersten, der zweiten beziehungsweise der dritten lichtemittierenden Diode befinden.

3. Anzeigetafel nach Anspruch 1 oder 2, wobei:
eine Fläche der ersten organischen photoelektrischen Umwandlungsdiode größer als oder gleich einer Fläche der ersten lichtemittierenden Diode ist;
eine Fläche der zweiten organischen photoelektrischen Umwandlungsdiode größer als oder gleich einer Fläche der zweiten lichtemittierenden Diode ist; und
eine Fläche der dritten organischen photoelektrischen Umwandlungsdiode größer als oder gleich einer Fläche der dritten lichtemittierenden Diode ist.

4. Anzeigetafel nach einem vorhergehenden Anspruch, wobei:
die erste organische photoelektrische Umwandlungsdiode dazu konfiguriert ist, Licht des ersten Wellenlängenspektrums, das von der ersten lichtemittierenden Diode emittiert wird, zu übertragen;
eine Halbwertsbreite (FWHM) des ersten Wellenlängenspektrums, das durch die erste organische photoelektrische Umwandlungsdiode übertragen wird, schmaler als eine FWHM des ersten Wellenlängenspektrums ist, das von der ersten lichtemittierenden Diode emittiert wird;
die zweite organische photoelektrische Umwandlungsdiode dazu konfiguriert ist, Licht des zweiten Wellenlängenspektrums, das von der zweiten lichtemittierenden Diode emittiert wird, zu übertragen;
eine FWHM des zweiten Wellenlängenspektrums, das durch die zweite organische photoelektrische Umwandlungsdiode übertragen wird, schmaler als eine FWHM des zweiten Wellenlängenspektrums ist, das von der zweiten lichtemittierenden Diode emittiert wird;
die dritte organische photoelektrische Umwandlungsdiode dazu konfiguriert ist, Licht des dritten Wellenlängenspektrums, das von der dritten lichtemittierenden Diode emittiert wird, zu übertragen; und
eine FWHM des dritten Wellenlängenspektrums, das durch die dritte organische photoelektrische Umwandlungsdiode übertragen wird, schmaler als eine FWHM des dritten Wellenlängenspektrums ist, das von der dritten lichtemittierenden Diode emittiert wird.

5. Anzeigetafel nach einem vorhergehenden Anspruch, wobei sich die erste, die zweite und die dritte lichtemittierende Diode und die erste, die zweite und die dritte organische photoelektrische Umwandlungsdiode eine gemeinsame Elektrode zum Anlegen einer gemeinsamen Spannung an die erste, die zweite und die dritte lichtemittierende Diode und die erste, die zweite und die dritte organische photoelektrische Umwandlungsdiode teilen.

6. Anzeigetafel nach Anspruch 5, wobei:
die erste, die zweite und die dritte lichtemittierende Diode erste Pixelelektroden für die erste, die zweite und die dritte lichtemittierende Diode enthalten, wobei die ersten Pixelelektroden der gemeinsamen Elektrode zugewandt und voneinander getrennt sind;
die erste, die zweite und die dritte organische photoelektrische Umwandlungsdiode zweite Pixelelektroden für erste, zweite und dritte organische photoelektrische Umwandlungsdiode enthalten, wobei die zweiten Pixelelektroden der gemeinsamen Elektrode zugewandt und voneinander getrennt sind; und
die ersten Pixelelektroden und die zweiten Pixelelektroden elektrisch mit voneinander verschiedenen Dünnfilmtransistoren verbunden sind.

7. Anzeigetafel nach einem vorhergehenden Anspruch, wobei:
die erste organische photoelektrische Umwandlungsdiode Folgendes enthält: ein organisches photoelektrisches Umwandlungsmaterial, das in der Lage ist, Licht des zweiten Wellenlängenspektrums und des dritten Wellenlängenspektrums selektiv zu absorbieren; oder eine Kombination aus einem organischen photoelektrischen Umwandlungsmaterial, das in der Lage ist, Licht des zweiten Wellenlängenspektrums selektiv zu absorbieren, und einem organischen photoelektrischen Umwandlungsmaterial, das in der Lage ist, Licht des dritten Wellenlängenspektrums selektiv zu absorbieren;
die zweite organische photoelektrische Umwandlungsdiode Folgendes enthält: ein organisches photoelektrisches Umwandlungsmaterial, das in der Lage ist, Licht des ersten Wellenlängenspektrums und des dritten Wellenlängenspektrums selektiv zu absorbieren; oder eine Kombination aus einem organischen photoelektrischen Umwandlungsmaterial, das in der Lage ist, Licht des ersten Wellenlängenspektrums selektiv zu absorbieren, und einem organischen photoelektrischen Umwandlungsmaterial, das in der Lage ist, Licht des dritten Wellenlängenspektrums selektiv zu absorbieren; und
die dritte organische photoelektrische Umwandlungsdiode Folgendes enthält: ein organisches photoelektrisches Umwandlungsmaterial, das in der Lage ist, Licht des ersten Wellenlängenspektrums und des zweiten Wellenlängenspektrums selektiv zu absorbieren; oder eine Kombination aus einem organischen photoelektrischen Umwandlungsmaterial, das in der Lage ist, Licht des ersten Wellenlängenspektrums selektiv zu absorbieren, und einem organischen photoelektrischen Umwandlungsmaterial, das in der Lage ist, Licht des zweiten Wellenlängenspektrums selektiv zu absorbieren.

8. Anzeigetafel nach einem vorhergehenden Anspruch, wobei:
das erste Wellenlängenspektrum ein blaues Wellenlängenspektrum mit einer maximalen Wellenlänge in einem ersten Wellenlängenspektrum von größer als oder gleich 380 nm und kleiner als 500 nm ist;
das zweite Wellenlängenspektrum ein grünes Wellenlängenspektrum mit einer maximalen Wellenlänge in einem zweiten Wellenlängenspektrum von 500 nm bis 600 nm ist; und
das dritte Wellenlängenspektrum ein rotes Wellenlängenspektrum mit einer maximalen Wellenlänge in einem dritten Wellenlängenspektrum von größer als 600 nm und kleiner als 750 nm ist.

9. Anzeigetafel nach einem vorhergehenden Anspruch, wobei:
mindestens eine von der zweiten organischen photoelektrischen Umwandlungsdiode oder der dritten organischen photoelektrischen Umwandlungsdiode dazu konfiguriert ist, das Licht des ersten Wellenlängenspektrums, das von der ersten lichtemittierenden Diode emittiert und durch ein Erkennungsziel reflektiert wird, zu erfassen;
mindestens eine von der ersten organischen photoelektrischen Umwandlungsdiode oder der dritten organischen photoelektrischen Umwandlungsdiode dazu konfiguriert ist, das Licht des zweiten Wellenlängenspektrums, das von der zweiten lichtemittierenden Diode emittiert und durch das Erkennungsziel reflektiert wird, zu erfassen; und
mindestens eine von der ersten organischen photoelektrischen Umwandlungsdiode oder der zweiten organischen photoelektrischen Umwandlungsdiode dazu konfiguriert ist, das Licht des dritten Wellenlängenspektrums, das von der dritten lichtemittierenden Diode emittiert und durch das Erkennungsziel reflektiert wird, zu erfassen.

10. Elektronische Vorrichtung, umfassend die Anzeigetafel gemäß einem vorhergehenden Anspruch.

## Revendications

1. Panneau d'affichage (1000), comprenant
un substrat (110),
de première, deuxième et troisième diodes électroluminescentes sur le substrat, les première, deuxième et troisième diodes électroluminescentes (210, 220, 230) étant conçues pour émettre de la lumière de premier, deuxième et troisième spectres de longueur d'onde, respectivement, les premier, deuxième et troisième spectres de longueur d'onde étant différents les uns des autres dans un spectre de lumière visible,
une première diode de conversion photoélectrique organique (310) chevauchant la première diode électroluminescente (210) le long d'une direction d'épaisseur du substrat, la première diode de conversion photoélectrique organique étant configurée pour absorber sélectivement de la lumière des deuxième et troisième spectres de longueur d'onde et convertir la lumière absorbée des deuxième et troisième spectres de longueur d'onde en un signal électrique,
une deuxième diode de conversion photoélectrique organique (320) chevauchant la deuxième diode électroluminescente (220) le long de la direction de l'épaisseur du substrat, la deuxième diode de conversion photoélectrique organique étant conçue pour absorber sélectivement de la lumière des premier et troisième spectres de longueur d'onde et convertir la lumière absorbée des premier et troisième spectres de longueur d'onde en un signal électrique, et
une troisième diode de conversion photoélectrique organique (330) chevauchant la troisième diode électroluminescente (230) le long de la direction d'épaisseur du substrat, la troisième diode de conversion photoélectrique organique étant configurée pour absorber sélectivement de la lumière des premier et deuxième spectres de longueur d'onde et convertir la lumière absorbée des deuxième et troisième spectres de longueur d'onde en un signal électrique.

2. Panneau d'affichage de la revendication 1, dans lequel
les première, deuxième et troisième diodes électroluminescentes sont agencées en parallèle le long d'une direction dans le plan du substrat, et
les première, deuxième et troisième diodes de conversion photoélectriques organiques sont agencées en parallèle le long d'une direction dans le plan du substrat, les première, deuxième et troisième diodes de conversion photoélectriques organiques étant sur les première, deuxième et troisième diodes électroluminescentes, respectivement.

3. Panneau d'affichage de la revendication 1 ou 2, dans lequel :
une aire de la première diode de conversion photoélectrique organique est supérieure ou égale à une aire de la première diode électroluminescente ;
une aire de la deuxième diode de conversion photoélectrique organique est supérieure ou égale à une aire de la deuxième diode électroluminescente ; et
une aire de la troisième diode de conversion photoélectrique organique est supérieure ou égale à une aire de la troisième diode électroluminescente.

4. Panneau d'affichage d'une quelconque revendication précédente, dans lequel :
la première diode de conversion photoélectrique organique est configurée pour transmettre de la lumière du premier spectre de longueur d'onde émise par la première diode électroluminescente ;
une largeur totale à mi-hauteur (FWHM) du premier spectre de longueur d'onde transmise à travers la première diode de conversion photoélectrique organique est plus étroite qu'une FWHM du premier spectre de longueur d'onde émise par la première diode électroluminescente ;
la deuxième diode de conversion photoélectrique organique est configurée pour transmettre de la lumière du deuxième spectre de longueur d'onde émise par la deuxième diode électroluminescente ;
une FWHM du deuxième spectre de longueur d'onde transmise à travers la deuxième diode de conversion photoélectrique organique est plus étroite qu'une FWHM du deuxième spectre de longueur d'onde émise par la deuxième diode électroluminescente ;
la troisième diode de conversion photoélectrique organique est configurée pour transmettre de la lumière du troisième spectre de longueur d'onde émise par la troisième diode électroluminescente ; et
une FWHM du troisième spectre de longueur d'onde transmise à travers la troisième diode de conversion photoélectrique organique est plus étroite qu'une FWHM du troisième spectre de longueur d'onde émise par la troisième diode électroluminescente.

5. Panneau d'affichage d'une quelconque revendication précédente, dans lequel les première, deuxième et troisième diodes électroluminescentes et les première, deuxième et troisième diodes de conversion photoélectriques organiques partagent une électrode commune pour appliquer une tension commune aux première, deuxième et troisième diodes électroluminescentes et aux première, deuxième et troisième diodes de conversion photoélectriques organiques.

6. Panneau d'affichage de la revendication 5, dans lequel :
les première, deuxième et troisième diodes électroluminescentes comprennent de premières électrodes de pixel pour les première, deuxième et troisième diodes électroluminescentes, les premières électrodes de pixel faisant face à l'électrode commune et étant séparées les unes des autres ;
les première, deuxième et troisième diodes de conversion photoélectriques organiques comprennent de secondes électrodes de pixel pour les première, deuxième et troisième diodes de conversion photoélectriques organiques, les secondes électrodes de pixel faisant face à l'électrode commune et étant séparées les unes des autres ; et
les premières électrodes de pixel et les secondes électrodes de pixel sont électriquement connectées à différents transistors à film mince les unes des autres.

7. Panneau d'affichage d'une quelconque revendication précédente, dans lequel :
la première diode de conversion photoélectrique organique comprend : un matériau de conversion photoélectrique organique capable d'absorber sélectivement de la lumière du deuxième spectre de longueur d'onde et du troisième spectre de longueur d'onde ; ou une combinaison d'un matériau de conversion photoélectrique organique capable d'absorber sélectivement de la lumière du deuxième spectre de longueur d'onde et d'un matériau de conversion photoélectrique organique capable d'absorber sélectivement de la lumière du troisième spectre de longueur d'onde ;
la deuxième diode de conversion photoélectrique organique comprend : un matériau de conversion photoélectrique organique capable d'absorber sélectivement de la lumière du premier spectre de longueur d'onde et du troisième spectre de longueur d'onde ; ou une combinaison d'un matériau de conversion photoélectrique organique capable d'absorber sélectivement de la lumière du premier spectre de longueur d'onde et d'un matériau de conversion photoélectrique organique capable d'absorber sélectivement de la lumière du troisième spectre de longueur d'onde ; et
la troisième diode de conversion photoélectrique organique comprend : un matériau de conversion photoélectrique organique capable d'absorber sélectivement de la lumière du premier spectre de longueur d'onde et du deuxième spectre de longueur d'onde ; ou une combinaison d'un matériau de conversion photoélectrique organique capable d'absorber sélectivement de la lumière du premier spectre de longueur d'onde et d'un matériau de conversion photoélectrique organique capable d'absorber sélectivement de la lumière du deuxième spectre de longueur d'onde.

8. Panneau d'affichage d'une quelconque revendication précédente, dans lequel :
le premier spectre de longueur d'onde est un spectre de longueur d'onde bleue présentant une longueur d'onde de crête dans un premier spectre de longueur d'onde supérieures ou égales à 380 nm et inférieure à 500 nm ;
le second spectre de longueur d'onde est un spectre de longueur d'onde verte présentant une longueur d'onde de crête dans un deuxième spectre de longueur d'onde de 500 nm à 600 nm ; et
le troisième spectre de longueur d'onde est un spectre de longueur d'onde rouge présentant une longueur d'onde de crête dans un troisième spectre de longueur d'onde supérieures à 600 nm et inférieures à 750 nm.

9. Panneau d'affichage d'une quelconque revendication précédente, dans lequel :
au moins l'une de la deuxième diode de conversion photoélectrique organique ou de la troisième diode de conversion photoélectrique organique est configurée pour détecter la lumière du premier spectre de longueur d'onde émise par la première diode électroluminescente et réfléchie par une cible de reconnaissance ;
au moins l'une de la première diode de conversion photoélectrique organique ou de la troisième diode de conversion photoélectrique organique est configurée pour détecter la lumière du deuxième spectre de longueur d'onde émise par la deuxième diode électroluminescente et réfléchie par la cible de reconnaissance ; et
au moins l'une de la première diode de conversion photoélectrique organique ou de la deuxième diode de conversion photoélectrique organique est configurée pour détecter la lumière du troisième spectre de longueur d'onde émise par la troisième diode électroluminescente et réfléchie par la cible de reconnaissance.

10. Dispositif électronique comprenant le panneau d'affichage selon une quelconque revendication précédente.
